# EUROPEAN PATENT APPLICATION

(11) **EP 1 510 994 A1**
(43) Date of publication of application: **02.03.2005**
(21) Application number: 04019965.5
(22) Date of filing: 23.08.2004
(51) Int. Cl.: G09F 9/33, G02F 1/1335, H04M 1/02

(54) **Display system and electronic appliance including the display**

(30) Priority: 21.08.2003 JP 2003208222
(71) Applicant: Pioneer Corporation, Tokyo-to (JP)
(72) Inventor: Kuroda, Kazuo c/o Pioneer Corporation, Tokorozawa-shi Saitama-ken (JP)
(74) Representative: Grünecker, Kinkeldey, Stockmair & Schwanhäusser Anwaltssozietät

(57) **Abstract**

A display system (1) having improved viewability and reduced in size and manufacturing cost has a display device (10) which includes an image forming layer (111) capable of emitting display light toward both front and back sides, and which can produce a display on a first surface (11) by a display lightportionemittedtowardthebacksideandproduceadisplay on a second surface (12) at the back of the first surface by a display light portion emitted toward the back side. The display also has an optical transmission control device (20, 21) which is placed along at least one of the first surface and the second surface, and which can control transmission of at least one of background light from a position at the back of the second surface as viewed from the first surface side and background light from a position at the back of the first surface as viewed from the second surface side.

## Description

### BACKGROUND OF THE INVENTION

### Field of the Invention

The present invention belongs to the field of displays including spontaneous luminescence devices such as electroluminescent devices (hereinafter referred to as "EL" as required).

### Description of the Related Art

Various displays have been provided. For example, in addition to traditional displays such as movie projectors in which a film is fed to a position in front of a light projecting unit to display an image on a screen, and displays having a cathode ray tube (CRT), recent proposals include liquid crystal displays, plasma displays, electroluminescent devices and the like. These kinds of displays are used in appliances in which importance is mainly attached to the functions of displays (e.g., television sets), as well as in other various kinds of electronic appliances. For example, these kinds of displays are used by being incorporated in portable appliances for use as a personal terminal (personal digital assistant (PDA) ) , such as electronic pocket notebooks, portable telephones, watches, personal computers, image pickup devices having a charge-coupled device (CCD) camera or the like (portable video cameras), as well as in image forming apparatuses, such as copying machines and facsimile machines. In these kinds of electronic appliances, displays are ordinarily used mainly for user interfaces.

It is well known that, in portable telephones, for example, the displays are used to inform users of the amount of remaining battery charge, a radio wave condition, a mail reception condition, a date, time, etc. Also, some of the various portable telephones already provided have such a construction that a casing in which mainly the display is provided and another casing in which push buttons or the like are mounted are connected so as to be rotatable relative to be each other and so that the two casings allow the entire body to be foldable. Such portable telephones include those provided in such a form that a display for informing a user of an incoming call, mail reception or the like when the portable telephone is in the folded state is provided, in addition to another display for enabling a user to check an operated condition or the like mainly at the time of push button operation (that is, when the portable telephone is not in the folded state) . Further, another form has been also provided which has display screens in both of the front and back surfaces of the portable telephone through each of which an incoming call, mail reception and an operated condition can be checked with a single display device using a liquid crystal display device (see, JP-2001-186226-A, JP-2001-186227-A and JP-2002-320012-A, for example).

In any case, displays have come into widespread use in the whole world, for example, by being incorporated in the above mentioned various kinds of electronic appliances to greatly contribute to social benefits including an improvement in efficiency as well as to give users of electronic appliances various kinds of convenience and comfortability or the like.

The conventional displays, however, have problems described below. The portable telephones described in JP-2001-186226-A or JP-2001-186227-A, for example, use a single display device and, therefore, a background or so existing at the rear of the display device is visually recognized through the display simultaneously with an image on the display. In this case, display contents on the display are visually recognized in a state of being superposed on the background at the rear. Thus, there is a technical problem that it is difficult or impossible to clearly and suitably recognize display contents, depending on the condition of the display contents (e. g. , high-definition) . That is, there is a problem that the essential function of the display to display images and information cannot be satisfactorily performed.

The portable telephones described in JP-2001-186226-A or JP-2001-186227-A use the liquid crystal display device and therefore require various parts including a backlight to improve the viewability. For this reason, the downsizing of the display device is necessarily limited and thus there is a technical problem that the conventional art does not contribute to a reduction in size of appliances such as portable telephones and PDAs in which importance is essentially attached to portability.

### SUMMARY OF THE INVENTION

In view of the above described problems, an object of the present invention is to provide a display system having improved viewability and reduced in size and cost and an electronic appliance using the display system.

To achieve the above described object, according to one aspect of the present invention, there is provided a display system having a display device including an image forming layer capable of emitting display light toward both front and back sides, the display device being capable of producing a display on a first surface by a display light portion emitted toward the front side and producing a display on a second surface at the back of the first surface by a display light portion emitted toward the back side, and an optical transmission control device placed along at least one of the first surface and the second surface, the optical transmission control device controlling transmission of at least one of background light from a position at the back of the second surface as viewed from the first surface side and background light from a position at the back of the first surface as viewed from the second surface side.

According to another aspect of the present invention, there is provided an electronic appliance having the above described display system and an operating button which influences a content of an image displayed in the display system.

These and other functions and advantages of the present invention will become apparent from the following description of embodiments of the invention.

### BRIEF DESCRIPTION OF THE DRAWINGS

FIGS. 1A and 1B are block diagrams schematically showing basic constructions of a display system in a first embodiment of the present invention;
FIG. 2 is a cross-sectional view schematically showing details of the construction of a display unit in the display system in the first embodiment;
FIG. 3 is a cross-sectional view schematically showing the state of light passing through polarizing plates in the display system in the first embodiment;
FIGS. 4A and 4B are diagrams schematically showing display modes in the display system in the first embodiment;
FIGS. 5A, 5B, and 5C are cross-sectional views schematically showing the state of light passing through a shutter in an example of modification of the display system in the first embodiment;
FIGS. 6A and 68 are cross-sectional views schematically showing details of the construction the shutter in the example of modification of the display system in the first embodiment;
FIGS. 7A and 7B are diagrams schematically showing display modes in the example of modification of the display system in the first embodiment;
FIGS. 8A, 8B, and 8C are diagrams schematically showing a portable telephone having the display system in the first embodiment;
FIGS. 9A and 9B are diagrams schematically showing a portable telephone having the display system in the example of modification of the first embodiment;
FIG. 10 is a block diagram schematically showing the basis construction of a display system in a second embodiment of the present invention;
FIG. 11 is a diagram schematically showing components for realizing operations relating to image change in the display system in the second embodiment;
FIGS. 12A, 12B and 12C are diagrams schematically showing display modes in the display system in the second embodiment;
FIGS. 13A, 13B, 13C, and 13D are diagrams schematically showing image change modes in the display system in the second embodiment;
FIGS. 14A, 14B, 14C, and 14D are diagrams schematically showing an example of modification of the display system in the second embodiment;
FIGS. 15A, 15B, 15C, and 15D are diagrams schematically showing another example of modification of the display system in the second embodiment;
FIG. 16 is a diagram schematically showing a video camera having the display system in the second embodiment;
FIG. 17 is a block diagram schematically showing the basic construction of a display system in a third embodiment of the present invention; and
FIGS. 18A and 18B are cross-sectional views schematically showing modes of transmission of background light in the display system in the third embodiment.

### DETAILED DESCRIPTION OF THE PREFERRED EMBODIMENTS

Now, some embodiments of the present invention will be described below.

A display system as one embodiment of the present invention has a display device including an image forming layer capable of emitting display light toward both front and back sides, the display device being capable of producing a display on a first surface by a display light portion emitted toward the front side and producing a display on a second surface at the back of the first surface by a display light portion emitted toward the back side, and an optical transmission control device placed along at least one of the first surface and the second surface, the optical transmission control device controlling transmission of at least one of background light from a position at the back of the second surface as viewed from the first surface side and background light from a position at the back of the first surface as viewed from the second surface side.

According to the embodiment of the display of the present invention, display light may be emitted from the image forming layer toward both the front and back surfaces or toward the front surface or the back surface at an arbitrary time during operation of the display. The image forming layer may emit display light toward both the front and back sides, or toward the front side or the back side by its spontaneous luminescence function. Alternatively, the image forming layer may emit display light toward both the front and back sides, or toward the front side or the back side by utilizing external light or a light source. When such display light is emitted, a video, an image or the like formed by the display light (i. e., display contents displayed by the display device or the display system) is displayed on each of the first surface and the second surface of the display device.

In particular, in this embodiment, the optical transmission control device is placed along at least one of the first surface and the second surface. The optical transmission control device is arranged to control transmission at least one of background light from a position at the back of the second surface as viewed from the front side (i.e., the first surface side) and background light from a position at the back of the first surface as viewed from the back side (i.e., the second surface side). "Background light" in the present invention broadly denotes external light other than the display light emitted from the image forming layer, including any light (other than the display light) visually recognized by the viewer through the display device. As the optical transmission device, polarizing plates placed on the opposite sides of the display device, a liquid crystal filter or any of various shutters for example can be used, as described below. For "control of transmission of light" in the present invention, transmission of light or blocking of light at a predetermined point in time may suffice. "Control of transmission of light" broadly denotes various conditions including, for example, a condition for enabling transmission or blocking of light only by combining a plurality of components such as two polarizing plates as described below. A change control device may also select between these conditions to control transmission of light, as described below. Further, "blocking of background light" at the time of "transmission control" by the optical transmission control device is a concept including blocking of approximately 100% of background light entering from a position at the back of the display device, and reducing the intensity of background light to such a level that the background light is invisible by the viewer or that at least the fact that the background light has been reduced is visually recognizable. If the background light can be reduced to a certain extent by the optical transmission control device no matter what the operation, the facility with which the image displayed by the display light is recognized can be improved according to the reduction in the amount of background light, as described below.

Further, the optical transmission control device may be arranged to separately control transmission of the display light emitted from the image forming layer toward the front side and the display light emitted from the image forming layertothebackside, asdescribedbelow. Also, transmission control of display light portions may be performed selectively and separately by electrooptically, mechanically or electrochemically changing the transmittance. In such a case, transmission control may be performed so that an unnecessary display light portion is blocked or the transmittance is reduced with respect to the unnecessary display light portion, as is control of transmission of background light. The arrangement may alternatively be such that while transmission of background light is controlled at all times by means of an optical system, transmission of display light portions is separately controlled. "Transmission control" further comprises transmission of approximately 100% of the display light and transmission of the display light to such an extent that the display light is can be visually recognized by the viewer.

For example, if transmission of the display light emitted to the first surface side is separately controlled by the optical transmission control device (for example, to transmit the display light) while transmission of the background light is controlled (for example, to block the background light), the viewer on the first surface side can suitably visually recognize display contents displayed by the display device without visually recognizing the background. If transmission of the background light is not controlled (if the background light is not blocked) , the viewer visually recognizes the background and the display contents in a superimposed state. If the display contents are easy to see and simple, the influence on the recognition of the display contents is small even though the display contents are superimposed on the background. However, if the display contents are complicated and detailed, there is a possibility of the viewer failing to suitably visually recognize the display contents when visually recognizing the display contents in the state of being superimposed on the background. In this embodiment, transmission of the background light can be suitably controlled, so that there is no possibility of occurrence of such a disadvantage.

Consequently, in the display system in this embodiment, the optical transmission control device controls (for example, blocks) transmission of light from the background for example to enable the viewer to suitably visually recognize the display contents displayed by the display device without visually recognizing the background. Thus, a display system having improved viewability can be realized even by using a single display. The display system in this embodiment can be realized byusing, for example, polarizing plates or a shutter described below. Therefore, the construction of the display system itself can be simplified and the display system can be easily mass-produced and can be produced at a low cost.

In another embodiment of the display system of the present invention, the aforementioned optical transmission control device controls transmission of at least one of the display light portion emitted toward the front side and the display light portion emitted toward the back side.

According to this embodiment, transmission of the display light is controlled to enable the viewer to visually recognize more suitably the display contents displayed by the display device, as described above.

In still another embodiment of the display system according to the present invention, the aforementioned optical transmission control device includes two polarizing elements respectively placed on the first surface side and the second surface side.

According to this embodiment, transmission of background light is controlled as described above by using a combination of two polarizing elements and a display system capable of separately controlling transmission of display light can be realized relatively easily. As each polarizing element, a polarizing plate or a liquid crystal shutter for example can be used, as described below.

In the embodiment of the display system including polarizing elements as described above, the two polarizing elements are formed of a pair of polarizing plates placed so that their polarization angles are different from each other.

In this arrangement, light passing through one of the pair of polarizing plates passes this polarizing plate without being blocked, while light passing through both of the pair of polarizing plates is blocked. Therefore, the display light emitted from the image forming layer toward the front side or the back side passes through the one polarizing plate placed on the first surface side or the second surface side of two polarizing plates to propagate to the position of the viewer. Consequently, the viewer can suitably visually recognize the display light.

On the other hand, background light propagating from a position at the back of the display device (i.e., a position opposite from the viewer) in the direction of transmission through the display device for example passes through each of the pair of polarizing plates. The pair of polarizing plates are placed so that their polarization angles are different from each other. "Polarization angle" in the present invention denotes the angle of the direction of oscillation of light passing through the polarizing plate. That is, a "state in which the polarization angles are different from each other" represents a state in which while one of the polarizing plates can transmit light oscillating in one direction, the other polarizing plate cannot transmit light oscillating in the one direction. In other words, the pair of polarizing plates are placed so that the directions of oscillation of light respectively transmittable through the pair of polarizing plates are different from each other and, therefore, the light oscillating in each direction cannot pass throughboth of the pair of polarizing plates . Therefore, the background light that cannot reach the position of the viewer unless it passes through the pair of polarizing plates is blocked by the pair of polarizing plates from reaching the position of the viewer. Consequently, the level of visual recognition of the background by the viewer is reduced.

As described above, the viewer can suitably visually recognize the display contents displayed by the display device.

Liquid crystal displays exist as the display system having two polarizing plates. Such liquid crystal displays, however, have such a construction that a light-emitting section, i.e., a backlight, is placed not between the pair of polarizing plates but outside the spacing between the polarizing plates, as is that described in JP-2002-320012-A. Therefore, even if a display system capable of visual recognition through each of the front and back sides like the display system in this embodiment of the present invention is realized by using such a liquid crystal display, the display system is incapable of control of transmission of background light according to the principle of display using the liquid crystal display due to the existence of the polarizing plates used for gradation of pixels according to an image signal. In this respect, the display system in this embodiment of the present invention is highly advantageous.

In the embodiment of the display system having the polarizing elements as described above, the polarization angle of at least one of the two polarizing elements is changed by application of a voltage.

According to this embodiment, the voltage applied to the polarizing element is controlled to change the polarization angle relatively easily. A liquid crystal shutter or the like may be used as the polarizing element. The polarization angle is changed on a pixel-by-pixel basis to display a letter, a pattern, a mark or the like.

In still another embodiment of the display system of the present invention, the optical transmittance of the optical transmission control device is changed by application of a voltage or a current.

According to this embodiment, a material the optical transmittance of which is changed by application of a voltage or a current, e.g., an electronic particulate/bulk material is used to enable background light transmission control to be relatively easily performed or to enable display light transmission control to be separately performed .

In a further embodiment of the display device of the present invention, display information is displayed by the optical transmission device.

According to this embodiment, a device such as a liquid crystal capable of changing the polarization angle can be used as the optical transmission device to display information such as a letter, a figure, a pattern, a mark or the like. That is, a killing-two-bird-with-one-stone effect of enabling control of transmission of the background light or the display light and displaying display information can be obtained by using the optical transmission device.

In still a further embodiment of the display system of the present invention, the optical transmission control device comprises a mechanical shutter.

According to this embodiment, selection can be performed between relatively easy display light transmission control and separate light transmission control.

The optical transmission control device comprising an electronic particulate/bulk material or a mechanical shutter can control (for example, block) transmission of background light from one of the first display surface side and the second display surface side (for example, background light propagating from the first surface side toward the second surface side) even when it is placed not on both the first and second surface sides but on one side (for example, on the first surface side). Even in this case, therefore, the viewer on the other side (for example, on the second surface side) can suitably visually recognize the display contents without visually recognizing the background light.

In still a further embodiment of the display system of the present invention, the optical transmission control device is placed on each of the first surface side and the second surface side, and the display further has a change control device of controlling change of the two optical transmission control devices between a state of blocking the background light from the position at the back of the second surface and transmitting the display light portion emitted toward the front side, and a state of blocking the background light from the position at the back of the first surface and transmitting the display light portion emitted to the back side.

According to this embodiment, the operation of the change control device enables both the viewer viewing from the first surface side and the viewer viewing from the second surface side to recognize the display contents displayed by the display device without visually recognizing the background. It is preferred that the changing operation of the change control device be executed according to whether the viewer is on the first surface side or on the second surface side.

Change by the change control device can be realized, for example, by changing a voltage applied to a polarizing element such as a liquid crystal shutter, by adjusting a voltage or current applied to an optical transmission control device such as an electronic particulate/bulk material, or by the opening/closing operation of a mechanical shutter. For example, this change may be made on the basis of a command from the viewer, or may be automatically made according to a display content or the like under the control of a microcomputer or the like.

In still a further embodiment of the display system of the present invention, the display system may comprise a spontaneous luminescence display unit which displays on the second surface a second image obtained by flipping a first image in a first state in which the first image is displayed on the first surface, and which displays the second image on the first surface in a second state in which the first image is displayed on the second surface.

According to this embodiment, the first image or the second image obtained by flipping the first image can be suitably displayed.

In the embodiment in which the display system has the first state and the second state as described above, the display system may further have a display change device of changing alternately the first state and the second state.

According to this arrangement, as described above, the display change device can select between display of the first image and display of the second image, the first and second images differing from each other or being horizontally or vertically flipped from one to another. More specifically, it is preferable to perform selection in such a manner that a suitable image (i.e., an image those display contents can be suitably visually recognized) is displayed on the first surface side when the main viewer is on the first surface side, and the suitable image is displayed on the second surface side when the main viewer is on the second surface side, thereby enabling each of the viewer viewing from the first surface side and the viewer viewing from the second surface side to suitably visually recognize the display contents displayed by the display device.

If the change control device is provided as described above, the optical transmission control device may be controlled in such a manner that transmission of the background light or the display light can be suitably controlled for the viewer positioned on the side where such a suitable image is displayed, according to whether the side where the suitable image is displayed by the operation of the display change device is the first surface side or the second surface side.

In the embodiment of the display system having the display change device as described above, the display change device may include an image change switch for selection according to an external operation or a predetermined operation relating to the display system.

According to this embodiment, the image change switch can be operated to select between the first state and the second state or between display of the first image and display of the second image, the first and second images differing from each other or being horizontally or vertically flipped from one to another as described above. The "image change switch" may be typically one of various buttons and switches or an operating device such as a remote controller, which is directly operated by the user (e.g., the viewer) of the display system.

In the embodiment of the display system having the display change device as described above, the display change device may include an image data inversion device of selecting between the first state and the second state by inverting image data input to the display device for image display on the first or second surface.

According to this arrangement, the image data inversion device is provided to improve, for example, the facility with which selection is performed between the first state and the second state or between the first image and the second image flipped horizontally or vertically from one to another as described above. That is, inversion of the image data input to the displaymay suffice for the selection. Advantageously, there is no need to change the drive method with respect to drive after the input.

In the embodiment of the display system having the display change device as described above, the display device may have a plurality of signal lines for image display arranged on a plane along the first or second surfaces, and a signal line drive device of driving the plurality of signal lines for image display, and the display change device may perform selection by reversing the order in which the plurality of signals lines for image display in the signal line drive device are driven.

According to this arrangement, the above described selection between the first state and the second states or between the first image and the second image flipped horizontally or vertically from one to another can be performed more easily in a case where image display is performed by means of pieces of light-emitting layer (i.e. , image forming layer) arranged in a matrix form. For example, in a case where active-matrix drive or passive-matrix drive is performed by using a plurality of scanning lines and a plurality of signal lines formed so as to intersect each other, the order in which a scanning line drive circuit drives the scanning lines may be reversed to obtain a reversed image flipped along a direction perpendicular to the direction in which the scanning lines extend, i.e., a vertically flipped image. Also in this case, the order in which an image signal line drive circuit drives the image signal lines may be reversed to obtain a revered image flipped along a direction perpendicular to the direction in which the signals lines extend, i.e., a horizontally flipped image. Further, the order in which the two drive circuits drive may be reversed to obtain a reversed image flipped vertically and horizontally.

That is, changing the drive method with respect to drive after input of the image data to the display system without inverting the image data may suffice for the selection. Both the input image data and the drive method may be changed for selection between the first image and the second image.

In the embodiment of the display having the display change device as described above, the display may further have a first casing in which the display device is accommodated, and a second casing openably and closably connected to the first casing, and the display change device may control the display device according to the opened/closed state of the second casing.

According to this arrangement, selection between the first state and the second states or between the first image and the second image flipped horizontally or vertically from one to another is automatically performed by the display change device according to the opened/closed state when the first casing and the second casing are opened from the closed state or reversely operated. In this case, a form of use of the display system may be ordinarily supposed in which the viewer faces the "first surface" when the first casing and the second casing is in a folded state, which is an example of the closed state, and, conversely, the viewer faces the "second surface" when the first casing and the second casing are in the opened state. In this case, therefore, it is preferable to perform selection in such a manner that a suitable image is displayed on the first surface when the first and second casings are in the folded state, and the suitable image is displayed on the second surface when the first and second casings are in the opened state. If selection is automatically performed as described above, the user is not required to perform any additional operation. Even in a case where the user is required to perform an additional operation, the user can easily obtain suitable information.

As a more concrete form of the display system of the present invention, a foldable portable telephone, a video camera, and a notebook-type personal computer may be mentioned.

The display change device may also include a distance sensor or the like for measuring the distance between the first casing and the second casing to enable determination of the opened/closed state of the second casing. If the distance between the first casing and the second casing measured with the distance sensor is in a predetermined distance, it may be determined that the second casing is in the opened state. Also, the display system may be automatically changed according to the determination result obtained by using the distance sensor.

In still a further embodiment of the display system of the present invention, the display device includes an electroluminescent display device.

According to this embodiment, the display system of the present invention, particularly the display device including a light emitting layer (i.e., image forming layer) can be more suitably constructed.

The electroluminescent display device ("electroluminecent" will be abbreviated as "EL" as occasion demands) may be of a bottom emission type, a top emission type, or a transparent type. For example, a "bottom emission type" of device is an organic EL display device in which light emitted from an organic EL light-emitting layer propagates to an ITO electrode side (i.e., the substrate side), which corresponds to an example of a transparent substrate layer. A "top emission type" of device is, for example, an organic EL display device in which light emitted from an organic EL light-emitting layer propagates to a cathode side (i.e., a side opposite from the substrate side). A "transparent type" of device is, for example, an organic EL display device in which light emitted from an organic EL light-emitting layer propagates to both cathode and ITO electrode sides. Also, an active-matrix drive system or a passive-matrix drive system may be used.

The "electroluminescent display device" referred to with respect to this embodiment involves any inorganic EL display device.

In still a further embodiment of the display system of the present invention, the display system further has a photosensor for detecting the intensity of the background light, and optical transmittance control device of changing the optical transmittance of the optical transmission control device on the basis of an output from the photosensor.

According to this embodiment, display contents more easily visually recognizable by the viewer can be displayed by the display device depending on the intensity of background. For example, the arrangement may be such that if the intensity of background light is higher than the intensity of display light, the optical transmittance of the optical transmission control device with respect to the background light is reduced (that is, the background light is blocked) to prevent the background light frombeingvisually recognized. On the other hand, the intensity of background light is negligibly small in comparison with the intensity of display light, it is possible to avoid visual recognition of the background light by the viewer without substantially largely increasing the optical transmittance of the optical transmission control device with respect to the background light.

In a embodiment of an electronic appliance of the present invention, the electronic appliance has the display system in one of the aforementioned embodiments (including various modified forms), and an operating button which influences a content of an image displayed in the display system.

According to the embodiment of the electronic appliance of the present invention, the electronic appliance has the display system in one of the aforementioned embodiments and can therefore be provided as an electronic appliance through which the aforementioned various benefits can be enjoyed, e.g., a television set, a portable personal terminal device such as an electronic packet notebook, a portable telephone, a watch, a personal computer or electronic paper, a finder for a camera having a charge-coupled device (CCD) (a portable video camera), as well as an image forming apparatus such as a copying machine or a facsimile machine, a ticket machine for selling a ticket or the like, an automated teller machine, or the like.

The "operating button" in the present invention influences a content of an image displayed in the display. For example, the operating button "influences a content" in such a manner that in a case where the operating button is a "power button" of the electronic appliance, the operating button is operated according to the method of use of the power button to select display/non-display of an image in the display system of the electronic appliance. The "operating button" in the present invention is not limited to those provided in electronic appliances. "Operating button" broadly denotes those externally operable, including a remote controller.

As described above, according to the embodiments of the display system of the present invention, display device and optical transmission control device are provided. Transmission of light from a background for example is controlled by the optical transmission control device to enable a viewer to suitably visually recognize display contents displayed by the display device without visually recognizing the background. Thus, a display system having improved viewability can be realized even by using a single display.

According to the embodiment of the electronic appliance of the present invention, the display system in one of the embodiments of the present invention and an operating button are provided. Any of various electronic appliances capable of blocking light from a background for example to enable a viewer to suitably visually recognize display contents displayed by the display device without visually recognizing the background can be easily manufactured and used.

### EXAMPLES

Some examples of the display system according to the present invention will be described with reference to the drawings.

### <First Example>

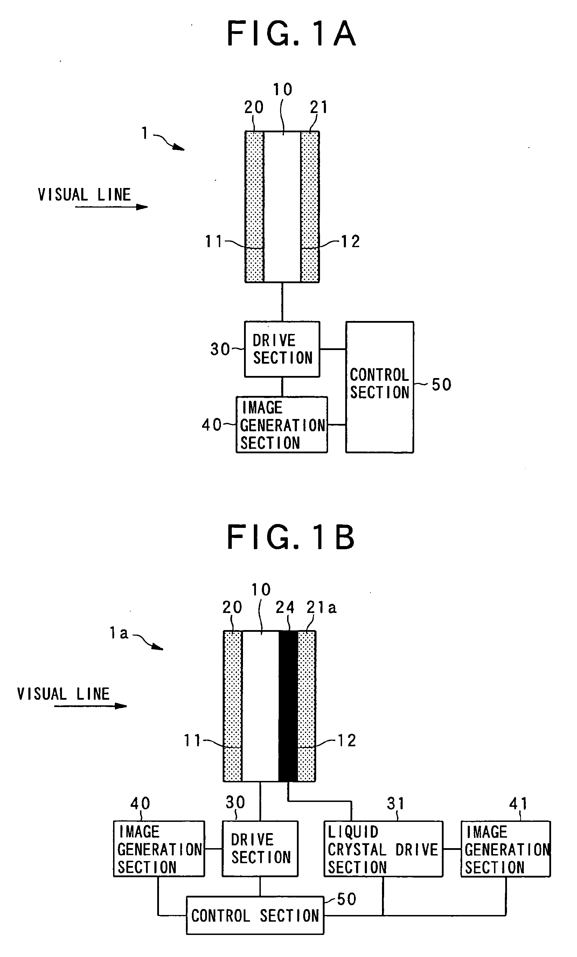

A display system in the first example of the present invention will be described with reference to FIGS. 1 to 6. In the display system in the first example of the present invention, a display unit, which is an example of "display device" in the present invention, is placed between two polarizing plates, which are an example of the light transmission control device in the present invention.

### Basic Construction

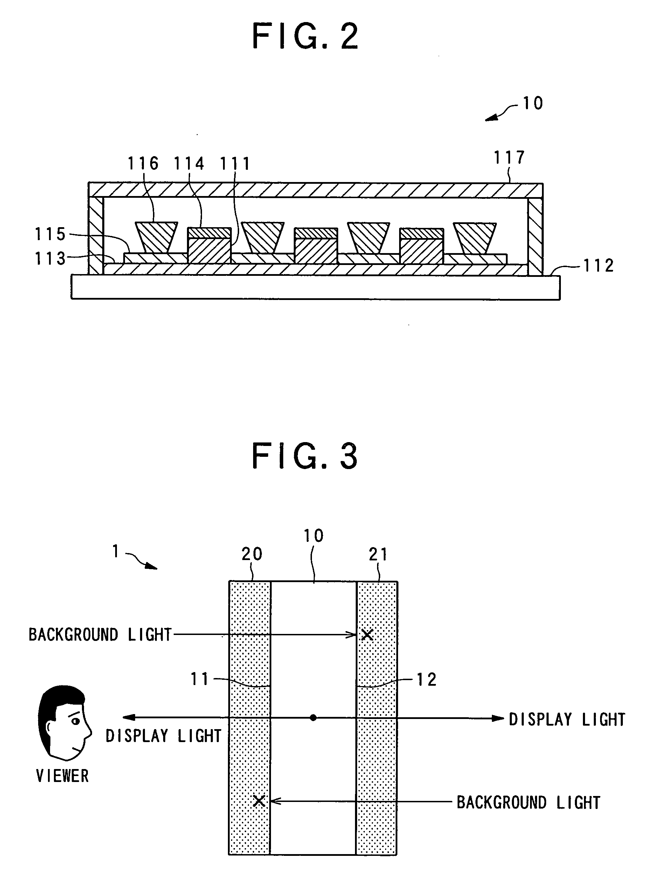

The basic construction of the display system in the first example of the present invention will be described with reference to FIGS. 1 to 2. FIG. 1A is a block diagram schematically showing a basic construction of the display system in the first example; FIG. 1B is a block diagram schematically showing another basic construction of the display system in the first example; and FIG. 2 is a cross-sectional view schematically showing details of the construction of a display device in the display system in the first example.

As shown in FIG. 1A, the display system 1 in this example has a display unit 10, which is an example of "display device" of the present invention, polarizing plates 20 and 21, which are an example of "light transmission control device" of the present invention, a drive section 30, an image generation section 40, and a control section 50.

The display unit 10 comprises a spontaneous luminescence transparent display and "has an image forming layer (see FIG. 2)" as described below. One surface of the display unit 10 is a first image display surface 11, while the other surface at the back side is a second image display surface 12. Only one display unit 10 is provided, as can be seen in FIG. 1A, and an image can be displayed in the front and back surfaces of the one display unit 10.

The display unit 10 may be, for example, an organic electroluminescent (EL) display, as shown in FIG. 2. If the display unit 10 is an organic EL display, it includes an organic EL light-emitting layer 111, which is an example of an "image forming layer" of the present invention, a substrate 112, an indium tin oxide (ITO) electrode (anode) 113, a transparent electrode (cathode) 114, an insulating film 115, a cathode partition wall 116 and a transparent glass encapsulation case 117.

The organic EL light-emitting layer 111 includes a hole injection layer, a hole transport layer, a light-emitting layer, an electron transport layer and an electron injection layer (each not shown). The hole injection layer is formed of CuPc (copper phthalocianine) for example; the hole transport layer is formed of NPB (N,N-di(naphthalene-1-yl)-N,N-diphenyl-benzidene) for example; the light-emitting layer is formed of Alq₃ (tris (8-hydroxyquinoline) aluminum) for example; the electron transport layer is formed of BCP (bathocuproine) for example; and the electron injection layer is formed of LiF (lithium fluoride) for example. Each pieces of organic EL light-emitting layer 111 forms one pixel. The pieces of organic EL light-emitting layer 111 may be equal in size to each other. The EL light-emitting layer 111 emits light forming a display light portion emitted on the first image display surface 11 side and a display light portion emitting on the second image display surface 12 side.

The substrate 112 protects and supports the organic EL light-emitting layer 111. The substrate 112 comprises a glass substrate for example. A polymer film may be used as a substrate instead of the glass substrate.

The ITO electrode 113 is an anode electrode having a light-transmitting property. A transparent IZO (indium zinc oxide) electrode may be used as the anode electrode instead of the transparent ITO electrode. In the case of a display unit 101 shown in FIG. 3, it is preferred that the refractive index of the ITO electrode 113 be equal to that of the substrate 112 from the viewpoint of reducing the reflection of display light at the interface. The transparent electrode 114 is, for example, a cathode electrode comprising IZO and having a light transmitting property. The transparent electrode 114 may be an electrode comprising ITO or a metallic electrode in the form of a thin film.

The insulating film 115 is a film for limiting current leakage. For example, the insulating film 115 is formed of polyimide over the substrate except at the positions at which the organic EL light-emitting layer 111 is formed. For patterning in a desired configuration at the time of forming of the cathodes, the cathode partition wall 116 is formed on the insulating film 115 so as to leave spaces where the cathodes are to be formed. The transparent glass encapsulation case 117 is a member for protecting the above described components from external influences. A transparent encapsulation film may be used in addition to or in place of the transparent glass encapsulation case.

In the display unit 10 having the above described structure, the ITO electrode 113 and the transparent electrode 114 each of which is transparent are provided on the upper and lower sides of the organic EL light-emitting layer 111 as viewed in FIG. 2. Therefore, light emitted from the organic EL light-emitting layer 111 is emitted in each of the upward and downward directions as viewed in FIG. 2. Thus, the display 1 in the first embodiment is capable of image display on each of the first image display surface 11 and the second image display surface 12, as shown in FIG. 1A.

Referring again to FIG. 1A, the polarizing plates 20 and 21 are, for example, glass plates or films having such a characteristic as to transmit light oscillating in a particular direction. In particular, in the first example, the direction of oscillation of light passing through the polarizing plate 20 and the direction oscillation of light passing through the polarizing plate 21 differ from each other. Therefore, transmission of light from the background can be suitably controlled and transmission of light emitted from the display unit 10 to a viewer can be suitably controlled separately, as described below.

A polarizing plate such as a glass film may be used as at least one of the polarizing plates 20 and 21. Alternatively, a liquid crystal may be used. In a case where a liquid crystal is used, the crystal orientation of liquid crystal molecules is controlled by changing a voltage applied to the liquid crystal. The polarization angle of the liquid crystal is thereby changed to enable light oscillating in a particular direction to pass through the liquid crystal. The same function as that of the polarizing plate 20 (21) can be performed by using the liquid crystal. A device for enabling a command for changing the voltage, e. g. , an operating button, a remote controller input section or the like may also be provided.

Display information such as a letter, a pattern or a mark may be displayed like a watermark by pixel-by-pixel control of an applied voltage using a transmission control plate. FIG. 1B shows an example of such control in a case where a liquid crystal device is used.

FIG. 1B shows an arrangement in which one polarizing plate 21 is replaced with a unit having a liquid crystal 24 interposed between a polarizing plate 21a and a glass plate. The polarization angle of the liquid crystal can be electrically changed. The polarization angle of the polarizing plate 21a is equal to that of the polarizing plate 20. An image generation section 41 generates display information to be displayed on the liquid crystal 24 under the control of the control section 50. A liquid crystal drive section 31 selects transmitting portions and non-transmitting portions by changing the polarization angle of the liquid crystal on a pixel-by-pixel basis on the basis of the generated display information, thereby displaying a pattern, a letter, a mark or the like on the liquid crystal surface. A liquid crystal unit is ordinarily constituted by two polarizing plates and a liquid crystal portion interposed between the polarizing plates. In this example, however, the self-light emitting device (i.e., the display unit 10) and the liquid crystal 24 are placed between the polarizing plates uniform in polarization direction as shown in FIG. 1B.

Referring again to FIG. 1A, the drive section 30 provided for drive of display on the display unit 10 makes the display unit 10 display a desired video, image or the like on the basis of an image input signal generated by the image generation section 40 described below. The drive section 30 may have the function of performing drive for producing an ornamental and effective display by selecting display timing, performing blinking or the like based on the control section 50.

The image generation section 40 generates an image to be displayed on the display unit 10, and stores the generated image. The image generation section 40 may record in a predetermined recording area an image externally supplied or an image generated by a personal computer or the like and read out the stored image when required. Processing for separately managing generated images and independently displaying the images may be performed. It is also possible to separately control images with respect to the position at which each image is displayed, the size, brightness and hues of the image, the form in which the image is displayed, shaping of the image, etc.

The control section 50 performs overall control on the display system 1. With respect to display of a three-dimensional image, the control section 50 sets a mode of display on the display unit 10 including a brightness and a size for example, and makes the image generation section 40 generate an image signal for display according to the display mode. The control section 50 also controls the operation of the drive section 30.

### Principle of Operation

The principle of the operation of the display system in the first example of the present invention will be described with reference to FIGS. 3 to 7.

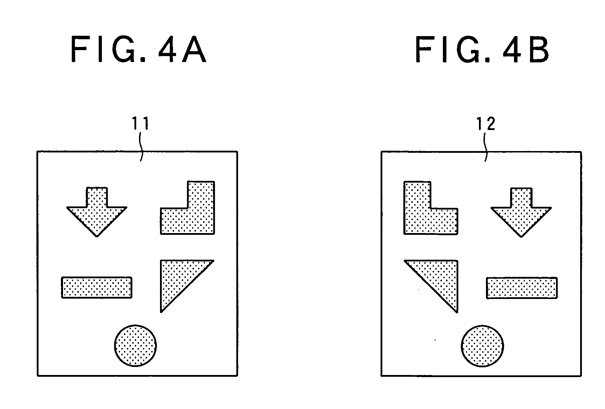

The basic principle of the operation of the display system in the first example will first be described with reference to FIGS. 3 and 4. FIG. 3 is a cross-sectional view schematically showing the state of light passing through the polarizing plate 20 (21), and FIGS. 4A and 4B are diagrams schematically showing display forms on the display system in the first example.

As shown in FIG. 3, a viewer who is a user of the display system 1 in the first example visually recognizes the contents of a display on the first image display surface 11 of the display unit 10. If the viewer is on the second image display surface 12 side, the viewer visually recognizes the display contents on the second image display surface 12 of the display unit 10. The viewer on the first image display surface 11 side will be referred to as "first viewer" as occasion demands, while the viewer on the second image display surface 12 side will be referred to as "second viewer" as occasion demands.

Display light emitted from the display unit 10 propagates to the position of the first viewer or the second viewer by passing through the polarizing plate 20 or 21. That is, display light emitted on the first image display surface 11 side passes through the polarizing plate 20 to be visually recognized by the viewer. On the other hand, display light emitted on the second image display surface 12 side passes through the polarizing plate 21 to be visually recognized by the viewer. In this case, since each display light passes the one polarizing plate 20 or 21, the polarization angle of the light is changed to a particular direction, e.g., a horizontal direction or a vertical direction. In other words, only light in a particular direction is allowed to pass through each polarizing plate, thereby enabling the viewer to suitably recognize display contents formed by the display light.

Background light is not visually recognized by the viewer unless it passes through each of the two polarizing plates 20 and 21. For example, background light propagating from the second image display surface 12 side passes through the polarizing plate 21 and then passes through the polarizing plate 20. The polarizing plates 20 and 21 are placed so that the oscillating directions of lights respectively passing therethrough are different from each other. Therefore, the light that has passes through the polarizing plate 21 cannot pass through the polarizing plate 20. The same can also be said with respect to background light propagating from the first image display surface 11 side. This background light cannot pass through the polarizing plate 21 after passing through the polarizing plate 20.

Consequently, background light does not reach the position of the first viewer or the second viewer and the first viewer or the second viewer does not visually recognize the background. If the background is visually recognizable, each of the first viewer and the second viewer visually recognizes the background and the display contents in a superimposed state. If the display contents are easy to see and simple, the influence on the recognition of the display contents is small even though the display contents are superimposed on the background. However, if the display contents are complicated and detailed, there is a possibility of the viewer failing to suitably visually recognize the display contents when visually recognizing the display contents in the state of being superimposed on the background. Further, if the background makes an impression of complicatedness for example, there is a possibility of the viewer failing to visually recognize any of the display contents on the display unit 10. The display system 1 in the first example has the remarkable advantage of enabling suitable visual recognition of essential display contents to be displayed on the display unit 10 while preventing visual recognition of the background. That is, the first viewer can suitably visually recognize display contents displayed on the first image display surface 11 and the second viewer can suitably visually recognize display contents displayed on the second image display surface 12.

Since the aforementioned benefit can be enjoyed if the polarizing plate 20 (21) is used, the construction of the display system itself can be simplified.

Even in the case of the display system 1a using the combination of the polarizing plate 21a and the liquid crystal 24 as shown in FIG. 1B, the polarization angle of the liquid crystal 24 is suitably changed to enable enjoyment of the same benefit as the aforementioned benefit in the case of the display system 1.

Display contents (i.e., images) respectively displayed on the first image display surface 11 and the second display surface will be described with reference to FIGS. 4A and 4B. The first viewer visually recognizes an image displayed on the first image display surface 11, as shown in FIG. 4A. On the other hand, when the same image is displayed by the display unit 10, the second viewer visually recognizes an image displayed on the second image display surface 12, as shown in FIG. 4B. That is, the images respectively displayed on the first image display surface 11 and the second image display surface 12 have the same contents but are in display forms reversed relative to each other. Even if the display contents are displayed in the reversed state as described above, each of the first viewer and the second viewer can visually recognize the corresponding display contents.

However, a mode of use is preferred in which one of the first viewer and the second viewer uses the display system 1. Such a mode of use may be, for example, use in a portable telephone or the like, as described below. Even in a case where both the first viewer and the second viewer simultaneously visually recognize the display contents, each viewer can suitably visually recognize the essential display contents displayed by the display unit 10 without visually recognizing the background.

### <Modified Examples>

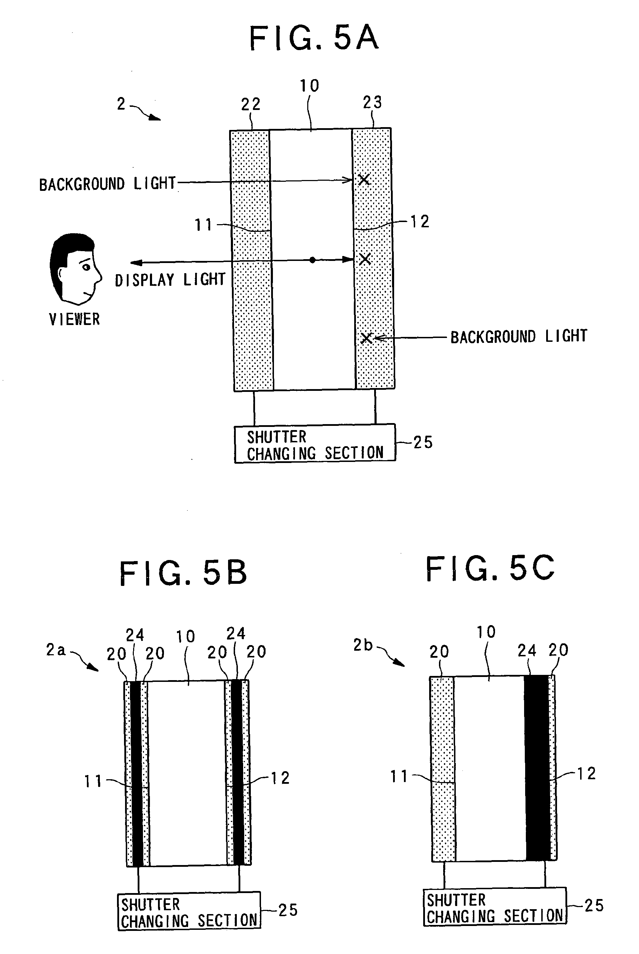

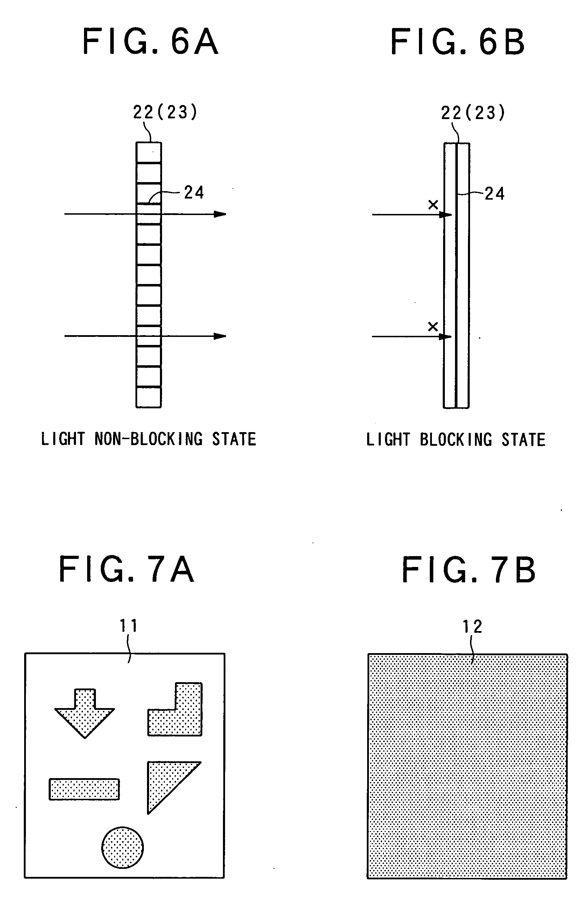

Examples modified from the display system in the aforementioned first example will be described with reference to FIGS. 5 to 7. FIGS. 5A, 5B, and 5C are cross-sectional views schematically showing the state of light passing through a shutter; FIGS. 6A and 6B are cross-sectional views schematically showing the construction of the shutter in more detail; and FIGS. 7A and 7B are diagrams schematically showing display forms on the display system in the first example. In this example modified from the first example, an arrangement is adopted in which a shutter 22 (23) is used in place of the polarizing plate 20 (21) provided in the aforementioned display system 1.

As shown in FIG. 5A, the display system 2 in the modified example has a construction similar with that of the display system 1 in the first example. Particularly in the display system 2, the shutter 22 (23) is used to block background light.

The shutter 22 (23) is arranged to select between a light-blocking state and a light-transmitting state. As the shutter 22 (23) , an electrical shutter including an electronic particulate/bulk material, a liquid crystal or the like may be used. Also, a mechanical shutter including a motor and a light-blocking shutter moved by the motor may be used.

The orientation of the electronic particulate/bulk material or the crystal orientation of the liquid crystal is changed by applying a voltage to enable selection between a light-blocking state and a light-transmitting state. FIGS. 5B and FIG. 5C are diagrams showing more concrete examples of use of a liquid crystal as the shutter 22 or 23.

As shown in FIG. 5B, a display system 2a has a liquid crystal 24 placed between a pair of polarizing plates 20 uniform in polarization direction in two pairs of polarizing plates 20 placed on opposite sides of the display unit 10 of the spontaneous luminescence device. Since the polarization directions of the polarizing plates 20 are the same, background light passes through the display if the polarization direction of the liquid crystals 24 is not changed. When the polarization direction of one liquid crystal 24 is changed, the corresponding portion functions as a shutter.

As shown in FIG. 5C, a display system 2b has such a construction that the image generation section 41 and the liquid crystal drive section 31 in the display system shown in FIG. 1B are simplified and a portion including the liquid crystal 24 functions as a shutter.

Referring again to FIG. 5A, a particular state of the display system 2 is shown in which the shutter 22 allows light to pass therethrough while the shutter 23 blocks light. In this state, display light emitted from the display unit 10 to the first image display surface 11 side passes through the shutter 22 to be visually recognized by the first viewer. On the other hand, display light emitted from the display unit 10 to the second image display surface 12 side is blocked by the shutter 23 from being visually recognized by the second viewer.

Background light propagating from the second image display surface 12 side to be visually recognized by the first viewer is blocked by the shutter 23 and does not reach the position of the first viewer. Consequently, the display system 2 shown in FIG. 5 enables the first viewer to suitably visually recognize the display contents displayed on the display unit 10 without visually recognizing the background. The same can also be said with respect to the display systems 2a and 2b shown in FIGS. 5B and 5C.

The construction of a mechanical shutter used as the shutter 22 (23) will be described in more detail. As shown in FIGS. 6A and 6B, shutter 22 (23) has a plurality of shutter windows 24 and the angle of which can be adjusted. The shutter windows 24 are linked to a power source such as a motor for adjustment of their angle.

FIG. 6A shows the state of the shutter 22 (23) in which the shutter can allow light to pass therethrough. Each of the shutter windows 24 is positioned parallel to the direction of traveling of light (e. g. , display light or background light). In this state, light passing through the shutter 22 (23) is not blocked in its optical path by the shutter windows 24. Thus, the shutter 22 (23) is in the state of allowing light to pass therethrough.

FIG. 6B shows the state of the shutter 22 (23) in which the shutter can block light. Each of the shutter windows 24 is positioned perpendicularly to the direction of traveling of light. In this state, light passing through the shutter 22 (23) is blocked in its optical path by the shutter windows 24. Thus, the shutter 22 (23) is in the state of being able to block light.

A shutter changing section 25 (see FIG. 5) may be provided which is capable of selecting between the light-blocking state and the light-transmitting state of the shutter 22 (23), and which is an example of "change control device" of the present invention. For example, if the shutter 22 (23) is a mechanical shutter, selection between the two states may be performed in such a manner that a motor for example is driven to change the angle of the transmission control shutter. If the shutter 22 (23) is an electrical shutter, selection between the two states may be performed in such a manner that a voltage (or current) applied to an electronic particulate/bulk material, a liquid crystal or the like for example is controlled. Selection between the two states may be performed according to a command from the viewer input by means of a remote controller or an operating button for example. Selection between the two states may be automatically performed under the control of the control section 50. In the case of selection by the control section 50, selection between the states may be performed according to the position of the viewer or display contents for example.

Display contents (i.e., images) respectively displayed on the first image display surface 11 and the second image display surface 12 in this arrangement will be described with reference to FIGS. 7A and 7B. The first viewer visually recognizes an image displayed on the first image display surface 11, as shown in FIG. 7A. On the other hand, an image displayed on the second image display surface 12 is not visually recognized by the second viewer with shutter 23. Thus, the image displayed by the display unit 10 is not displayed on the second image display surface 12, as shown in FIG. 7B.

### <Concrete Examples>

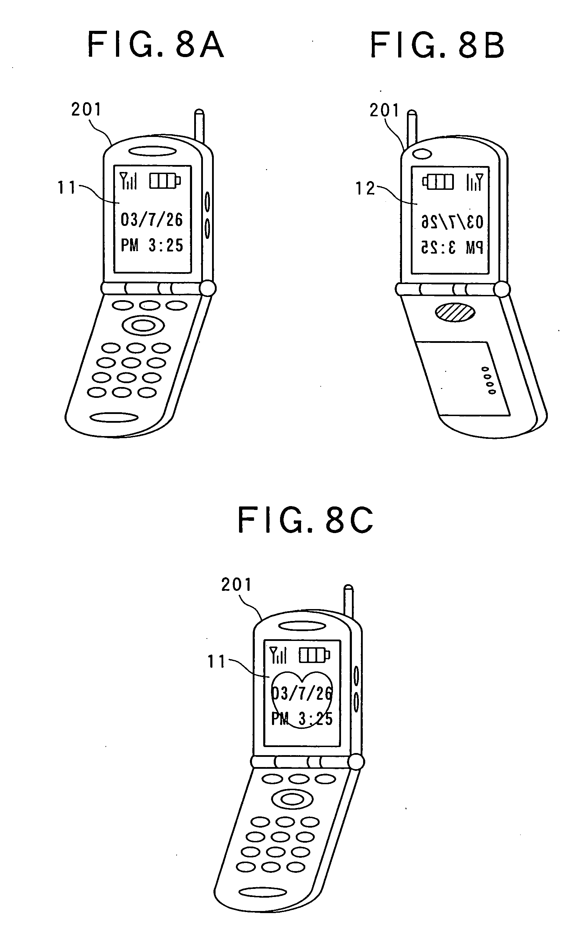

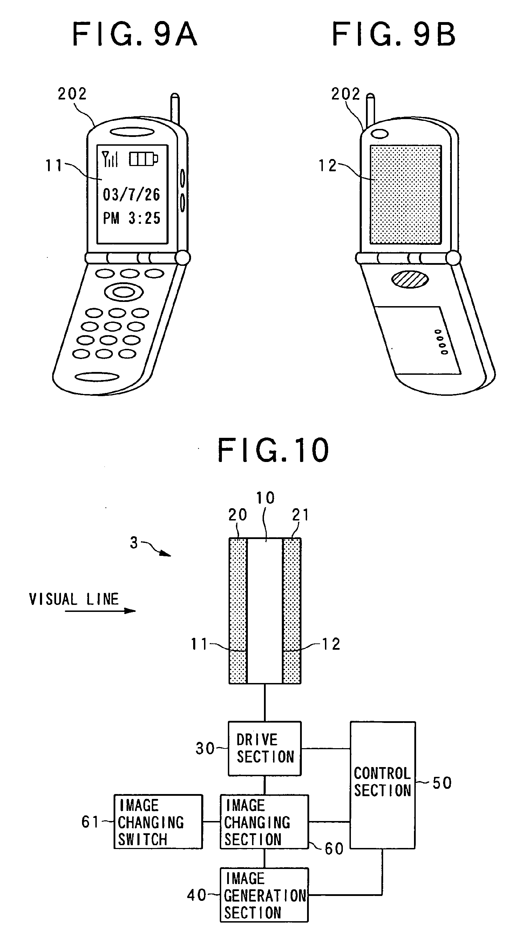

Concrete examples of use as concrete products (e.g., portable telephone) of the display system 1 in the first example and the display system 2 in the example modified from the display system 1, will be described with reference to FIGS. 8 and 9. FIGS. 8A, 8B, and 8C are diagram schematically showing a portable telephone having the display system 1, and FIGS. 9A and 9B are diagram schematically showing a portable telephone having the display system 2.

As shown in FIG. 8A, in the portable telephone 201 having the display system 1 in the first example, display contents are suitably displayed on a main display corresponding to the first image display surface 11 at the time of normal telephone conversation or button operation. At this time, an image formed by reversing the image displayed on the first image display surface 11 is displayed on a sub display (i.e., a back display) corresponding to the second image display surface 12 as shown in FIG. 8B. Also, background transmission control on display on each of the first and second display surfaces can be performed to enable transmission of light from the background or to reduce the amount of transmitted background light to substantially zero.

If the display has liquid crystal 24, the polarization angle of the liquid crystal 24 (i.e., the orientation of alignment of the liquid crystal) is changed on a pixel-by-pixel basis to display a display content by liquid crystal 24 (i.e., a heart mark) in addition to the display contents displayed by the display unit 10, as shown in FIG. 8C. Any other display content such as a letter, a pattern or a mark can be displayed. Further, transmission through the first image display surface 11 and the second image display surface 12 may be controlled in such a manner that a portion of the first image display surface 11 and/or a portion of the second image display surface 12 are in the light-transmitting state while the other portion while the other portions are in the light-blocking state.

Similarly, in the portable telephone 202 having the display system 2 in the example modified from the first example, a suitable image is suitably displayed on the first image display surface 11 at the time of normal telephone conversation or button operation, as shown in FIG. 9A. At this time, the shutter 22 is in the light-transmitting state while the shutter 23 is in the light-blocking state. Therefore, no image is displayed on the second image display surface 12, as shown in FIG. 9B.

As described above, in the display system according to the first example, transmission of light from the background for example is controlled by means of the polarizing plates or the like to enable the viewer to suitably visually recognize display contents displayed on the display unit without visually recognizing the background. Thus, a display system having improved viewability can be realized even by using a single display. The display system in the first example can be realized by using polarizing plates, a shutter or the like. Therefore, the construction of the display system itself can be simplified and the display system can be easily mass-produced and can be produced at a low cost.

### <Second Example>

A display in a second example of the present invention will be described with reference to FIGS. 10 to 14. The display system in the second example is a display system capable of suitably changing each of images respectively displayed on the aforementioned first image display surface 11 and second image display surface 12. The same components as those in the display system 1 in the first example described above are indicated by the same reference numerals and the detailed description of the same components will be omitted.

### Basic Construction

The basic construction of the display system in the second example will first be described with reference to FIG. 10. FIG. 10 is a block diagram schematically showing the basic construction of the display system in the second example.

As shown in FIG. 10, the display system 3 in the second example has a display unit 10, polarizing plates 20 and 21, a drive section 30, an image generation section 40 and a control section 50, as does the display system 1 in the first example.

The display system 3 in particular has an image change section 60, which is an example of "display change device" of the present invention. The image change section 60 is capable of changing each of images respectively displayed on the first image display surface 11 and the second image display surface 12 by reversing the image as desired, or otherwise changing the image.

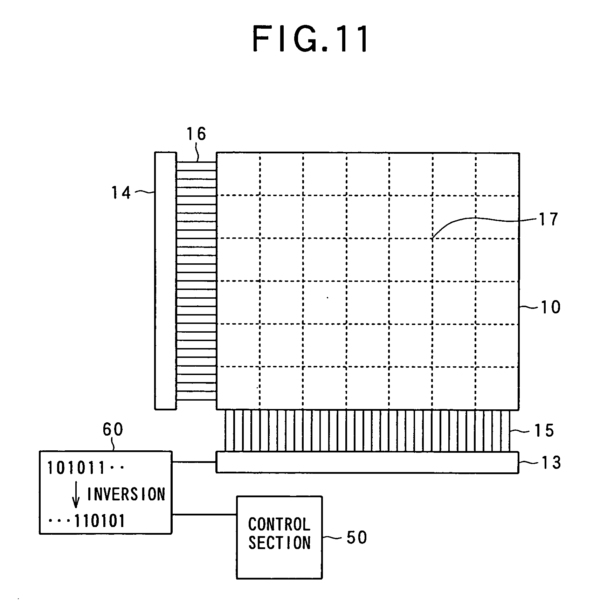

An image change switch 61 for providing an image change instruction to the image change section 60 may be provided. When the image change switch 61 is depressed, an image formed by horizontally flipping an image displayed on the first image display surface 11 is displayed on the second image display surface 12, as described below. More specifically, an arrangement for realizing such image change or, more generally, image display on the display unit 10 by using a circuit system such as shown in FIG. 11 may be adopted.

Referring to FIG. 11, the display unit 10 has scanning lines 16 and image signal lines 15. The pieces of organic EL light-emitting layer 111 described above with reference to FIG. 2 are placed so as to correspond to points of intersection X (i.e., points of intersection 17) of the scanning lines 16 and the image signal lines 15 arranged in grid form as shown in FIG. 11. (In FIG. 11, the scanning lines 16 and the image signal lines 15 in the image display surface are illustrated by being suitably thinned out to avoid complication.) The ITO electrodes 113 shown in FIG. 2 are electrically connected to the scanning lines 16, and the transparent electrodes 114 shown in FIG. 2 are electrically connected to the image signal lines 15, thereby enabling a potential difference to be caused between an opposed pair of the ITO electrodes 113 and the transparent electrodes 114 placed in correspondence with the points of intersection X when predetermined signals are supplied to the corresponding scanning line 16 and image signal line 15. Therefore, different voltages can be applied to the organic EL light-emitting layer 111 with respect to the points of intersection X to vary the degree of emission of light on a pixel-by-pixel basis.

The scanning lines 16 are connected to a scanning line drive circuit 14, while the image signal lines 15 are connected to an image signal line drive circuit 13. The image signal line drive circuit 13 is connected to the image change section 60, which in turn is connected to the image change switch 61.

Image display in the display unit 10 is realized as descried below. First, an image signal corresponding to one of the scanning lines 16 and used to display a predetermined image is generated by the image signal generation circuit 2. This signal is generated with respect to each of the image signal lines 15. For example, if the image signal is in such an extremely simple form as to be expressed by "1" and "0" alone, it is generated as represented by "101011 ..." in FIG. 11 are generated in the image change section 60. The digits in this sequence correspond to the image signal lines 15 in a one-to-one relationship. Second, this image signal is fed to the image signal lines 15 through the image signal line drive circuit 13, and a predetermined scanning signal is fed to one of the scanning lines 16, thereby applying predetermined electric fields to the pieces of organic EL light-emitting layer 111 corresponding to the points of intersection X prescribed by the image signal lines 15 and the one scanning line 16. Third, this processing is performed with respect to all the scanning lines 16 to display one image.

The image change switch 61 is operated as described below. That is, while the aforementioned image signal is generated as desired in the image change section 60, inversion of the image signal can be initiated by depressing the image change switch 61. More specifically, in a case where the original image signal is generated in the image change section 60, for example, as represented by "101011 ..." in the above, the image signal is inverted as "... 110101" when the image change switch 61 is depressed, thereby flipping the image on the first image display surface 11 or the second image display surface 12.

When the image signal is inverted in this manner, the image change section 60 operates as a concrete example of "image data inversion device" in the present invention.

### Principle of Operation

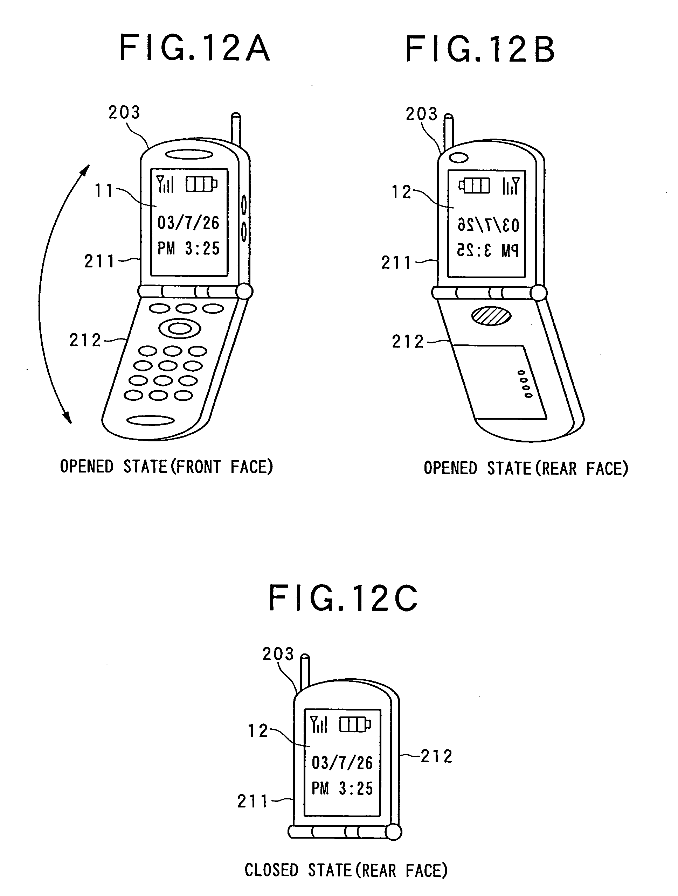

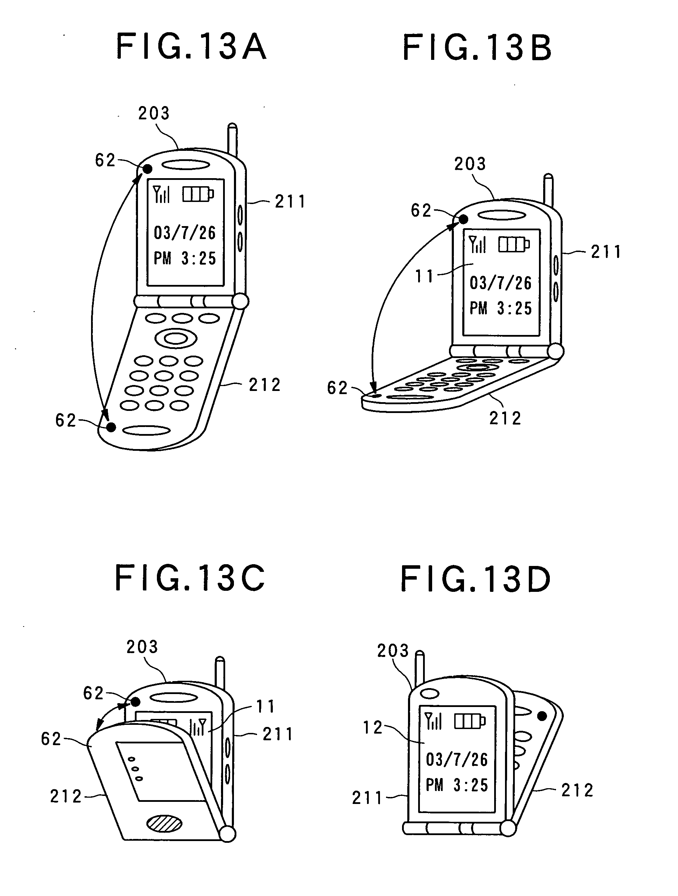

The principle of operation of the display system 3 in the second example will be described with reference to FIGS. 12 and 13. FIGS. 12A, 12B, and 12C are diagrams schematically showing display forms in the display system in the second example, and FIGS. 13A, 13B, 13C, and 13D are diagrams schematically showing image change modes in the display system in the second example. Description will be made with respect to a portable telephone having the display system 3 in the second example.

As shown in FIG. 12A, the portable telephone 203 having the display system 3 in the second example has a first casing 211 incorporating mainly a display portion (i.e., display system 3) and a speaker portion, and a second casing 212 incorporating mainly operating button portions and a microphone portion. The first casing 211 and the second casing 212 are connected to each other by a hinge so as to be rotatable (i.e., openable and closable) as indicated by arrows in FIG. 12A, thereby enabling the second casing 212 to be set in a folded state (see FIG. 12C) , which is an example of the "closed state" in the aforementioned example, and an opened state (see FIG. 12A or FIG. 12B) on the first casing 211 as seen about the first casing 211.

The display system 3 is mounted as it is inlaid in the first casing 211, with one surface exposed as the first image display surface 11 and the opposite surface exposed as the second image display surface 12. Image display can be performed on each of the first image display surface 11 and the second image display surface 12. A user (i.e. , a viewer) of the portable telephone 203 can visually recognize an image or the like on each of the first image display surface 11 and the second image display surface 12.

FIG. 12A shows a state in which the first casing and the second casing are opened relative to each other. In this state, a suitable image is displayed on the first image display surface 11. That is, the viewer views mainly the first image display surface when the potable telephone 203 is in the opened state.

At this time, the image displayed on the first image display surface 11 is displayed on the second image display surface 12 in a reversed (or flipped) state, as shown in FIG. 12B.

In such a case, in the second example, the viewer can change the display by depressing the image change switch 61 (not shown in FIGS. 12) in order to display a suitable image on the second image display surface 12. When the image change switch 61 is depressed, the sequence in the image signal in the image change section 60 corresponding to the image signal lines 13 is inverted, as described above. A suitable image corresponding to that displayed on the first image display surface 11 (i.e., the image shown in FIG. 12A) is thereby displayed on the second image display surface 12.

Thus, the display system 3 in the second example is capable of displaying an image useful to each of two viewers facing the display system 3 interposed between the viewers (i.e., the first viewer and the second viewer) . As a recent type of potable telephone, "a portable telephone with a camera" has also been put on the market. In such a portable telephone, the aforementioned display system 3 can be used a finder for the camera. In a case where the display system 3 is used as a finder, a device for changing an image between the case of ordinary picture taking (taking a picture of an object positioned in a direction in which the user faces) and the case where the user takes a picture of him/herself (the user sets him/herself as an object) may be conveniently used. In such a situation, if an image change switch such as that described above is provided, the user can manually perform image change to sufficiently utilize the finder function.

While the method of reversing an image by inverting the sequence in the image signal generated in the image change section 60 is described in the above, a different method may alternatively be used in this example. For example, an image can be reversedby changing the order in which sampling switches (not shown) provided in the image signal line drive circuit 13 shown in FIG. 11 to control timing of feed of the image signal to the image signal lines 15 are turned on and off. Also, while the arrangement has been described in which the scanning line drive circuit 14 for driving the scanning lines 16 is provided on only one side as viewed in FIG. 11, corresponding scanning line drive circuits may be provided on opposite sides.

Further, instead of changing an image by depressing the image change switch 61, selection between the first image display surface 11 and the second image display surface 12 for display of a suitable image may be performed as desired according to the state of the first casing 211 and the second casing 212 for example. For example, this selection may be automatically performed. For example, this selection may be performed to display a suitable image on the second image display surface 12 when the first casing 211 and the second casing 212 are in the closed state, as shown in FIG. 12C. In this manner, suitable information can be fed to the user of the portable telephone 203 without requiring the user to perform any additional operation. Even in a case where the user is required to perform an additional operation, the user can easily obtain suitable information.

To enable the aforementioned selection, the portable telephone 203 is provided with an image flip device (not shown) for horizontally flipping an image on the first image display surface 11 and an image on the second image display surface 12 relative to each other according to the difference between a state where the first casing 211 and the second casing 212 are relatively opened and a state where the first casing 211 and the second casing 212 are folded. This image flip device corresponds to the image change switch 61 shown in FIG. 10. However, an essential feature of the image flip device resides in that a direct button operation by the user such as the operation of the image change switch 61 is not required but image flipping is performed by automatically detecting whether the first casing 211 and the second casing 212 are in the opened state or the folded state.

A method of determining whether the portable telephone 203 is in the "opened state" or in the "closed state" may be used in which the distance between the first casing 211 and the second casing 212 is detected and the changing operation using the image change section 60 is performed on the basis of a change in the detected distance. If such a method is used, it is preferred that each of the first casing 211 and the second casing 212 have a distance sensor 62 capable of measuring the distance between the first and second casings, as shown in FIG. 13.

As shown in FIG. 13A, one of the two distance sensors 62 is provided in the first casing 211 in the vicinity of the speaker portion, while the other distance sensor 62 is provided in the second casing 212 in the vicinity of the microphone portion. The positions at which the sensors 62 are provided are not limited to these. Placement of the sensors 62 at any positions may suffice if the distance between the first casing 211 and the second casing 212 can be correctly measured.

In the state shown in FIG. 13A, the distance between the first casing 211 and the second casing 212 is suitably large and, therefore, the control section 50 determines that the portable telephone 203 is in the "opened state". The arrangement may be such that when this determination is made, the distance between the first casing 211 and the second casing 212 detected by the distance sensors 62 is output to the control section 50.

At this time, a suitable image is displayed on the first image display surface 11, as shown in FIG. 13A. An image formed by flipping this suitable image is displayed on the second image display surface 12. Even in this case, there is no problem with the display system since the user ordinarily performs a button operation or performs some of various operations by viewing the first image display surface 11 when the portable telephone 203 is in the "opened state".

When the first casing 211 and the second casing 212 are thereafter brought close to each other by a hinging operation as shown in FIG. 13B, the control section 50 also determines for example that the first casing 211 and the second casing 212 are in the "opened state", because the distance between the first casing 211 and the second casing 212 is still suitably large.

When the first casing 211 and the second casing 212 are further brought closer to each other as shown in FIG. 13C, the first casing 211 and the second casing 212 are not still in the completely "closed state". In the state shown in FIG. 13C, however, the first casing 211 and the second casing 212 can be considered substantially closed. Also, because of interference with the second casing 212, it is difficult to say that the image displayed on the first image display surface 11 can be suitably visually recognized by the viewer. Therefore, it is preferred that the control section 50 determine that the first casing 211 and the second casing 212 are in the "closed state" when the first casing 211 and the second casing 212 are brought closer to each other to such a degree.

At the stage shown in FIG. 13C, therefore, the changing operation is performed by the image change section 60 to display the suitable image in a flipped state on the first image display surface 11. On the other hand, the suitable image is displayed on the second image display surface 12, as shown in FIG. 13D.

The distance at which it is determined that the first casing 211 and the second casing 212 are in the closed state may be uniquely determined in advance or may be set to one of predetermined values as required. In any case, it is preferable to determine the distance at which it is determined whether the first casing 211 and the second casing 212 are in the "opened state" or the "closed state", according to whether the display surface easy for the viewer to see is the first image display surface 11 or the second image display surface 12 and according to whether the viewer is facing the first image display surface 11 or the second image display surface 12.

### <Modified Examples>

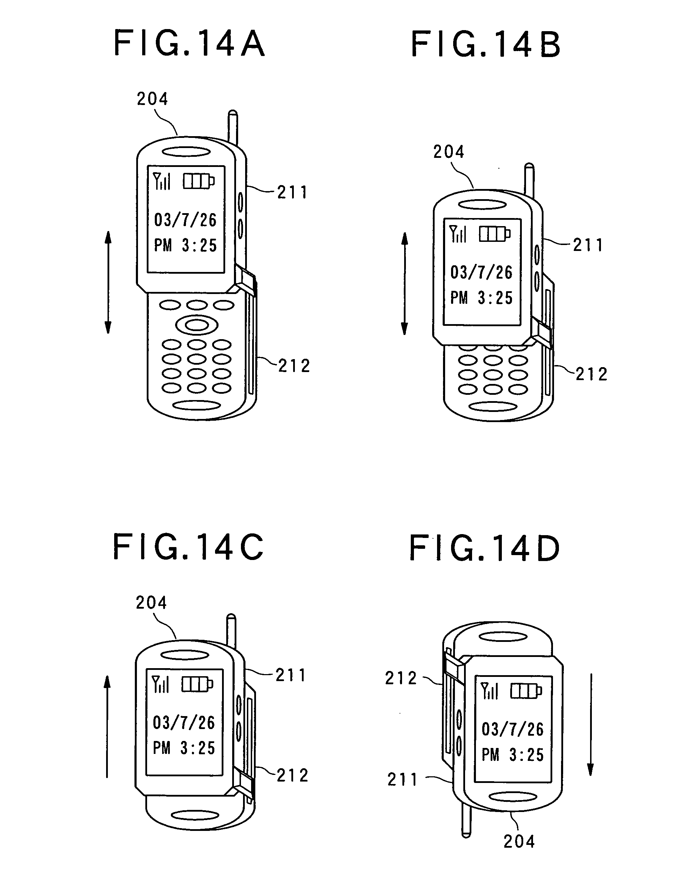

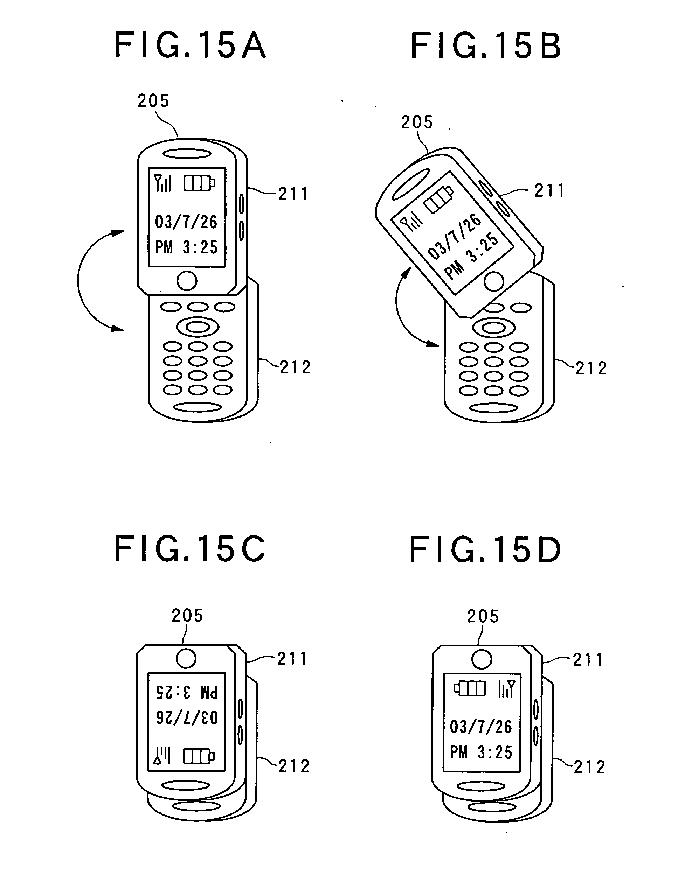

As concrete forms of portable telephones corresponding to examples modified from the aforementioned portable telephone, various types of potable telephones such as shown in FIGS. 14 and 15 have been proposed as well as the type shown in FIG. 12. FIGS. 14 and 15 are diagrams schematically showing modified examples of the portable telephone having the display system 3 in the second example.

FIGS. 14A to 14D show a type of portable telephone 204 which has no hinge and in which the first casing 211 slides openably and closably on the second casing 212 (from the state shown in FIG. 14A to the state shown in FIG. 14C via the state shown in FIG. 14B or in the reverse direction) . This system enables suitable use of the features of display system 3 in the second example at the time of image change between a state shown in FIG. 14C and a state in which an image is displayed by being vertically flipped as shown in FIG. 14D. An image (not shown) difficult to read is also displayed on the back surface in the state shown in FIG. 14A, as is the image shown in FIG. 12B. However, a normal image may be displayed on the back surface when the back surface is viewed as a front surface in some case.

The portable telephone 204 shown in FIGS. 14A to 14D has portions for the structure for sliding between the first casing 211 and the second casing 212, i.e., connecting portions 231 and slide grooves 232 for guiding the connecting portions 231. The arrangement may be such that determination as to the opened/closed states of the first casing 211 and the second casing 212 is made according to the position of the connecting portions 231.

An essential feature of the portable telephone 205 shown in FIGS. 15A to 15D resides in a hinge structure such that the first casing 211 and the second casing 212 rotate relative to each other on the hinge like a blade and a handle of a jackknife (from the state shown in FIG. 15A to the state shown in FIG. 15C via the state shown in FIG. 15B or in the reverse direction) . This system enables suitable use of the features of display system 3 in the second example at the time of image change from a state shown in FIG. 15C to a state shown in FIG. 14D or from the state shown in FIG. 14D to the state shown in FIG. 15C. An image (not shown) difficult to read is also displayed on the back surface in the state shown in FIG. 15A, as is the image shown in FIG. 12B. However, a suitable image may be displayed on the back surface when the back surface is viewed as a front surface in some case.

It can be said that the states shown in FIGS. 14C and 14D correspond to the "closed state" in the aforementioned examples. It can also be said that the states shown in FIGS. 15C and 15D correspond to the "opened state" in the aforementioned examples.

Also in the portable telephones shown in FIGS. 14 and 15, it is preferred that determination as to the "closed state" and the "opened state" be performed on the basis of the distance between the first casing 211 and the second casing 212, as in the portable telephone 203 in the second example.

Portable telephones 204 and 205 using various systems exist. However, the display system according to this example can be basically applied to any other potable telephones regardless of the opening/closing system.

Thus, the display in the second example is capable of displaying an image useful to each of two viewers facing the display interposed between the viewers (i. e. , the first viewer and the second viewer), of displaying a suitable image on the most suitable or more suitable image display surface in accordance with a condition under which a user uses the display system.

The method of executing an image flip as described above with reference to FIG. 11 is not exclusively used. That is, also in association with initiation of an image flip described above, image flipping may be performed on a piece of software such as image drawing program installed on a personal computer for example (at a side closer to a user) . If an image flipping method using such a piece of software is used, image flipping can be performed with markedly improved flexibility. For example, a process can be performed in which a suitable image and an image formed by flipping the suitable image are simultaneously developed on the screens with external operations of a keyboard, a mouse or the like. Also, a flip of only a portion of an image can easily be realized by programming or by a user freely making a setting on a piece of software.

The display systems in the first and second examples have been described with respect to cases of application to portable telephones. Needless to say, the display systems in the first and second examples can also be applied to other various electronic appliances.

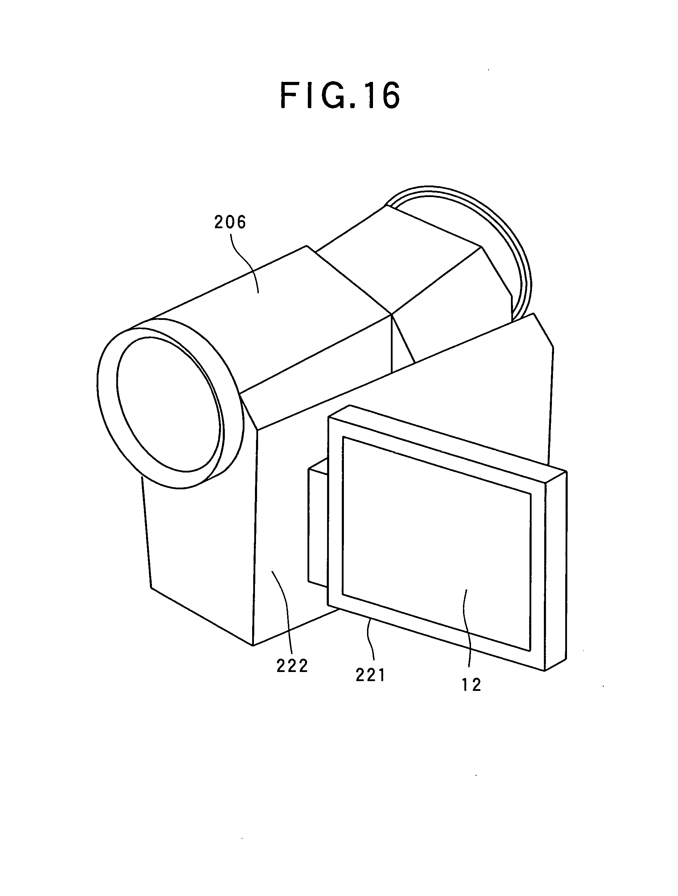

For example, as shown in FIG. 16, the display systems can be applied to an image pickup device having a charge-coupled device (CCD) camera or the like (hereinafter referred to as "video camera") . An existing video camera 206 is known which uses a display as its finder, and in which the finder or the display is rotatably connected to the portable video camera main body 206 by a special mechanical structure. For example, the finder or the display is used to enable an object of picture taking to check how a recording is performed. If the display system in the first or second example is applied to the finder, the same effects as those aforementioned effects can be obtained without using the above mentioned special mechanical structure, because each of the displays in the second example has the first image display surface 11 and the second image display surface 12 capable of image display or visual recognition. While only the second image display surface 12 is illustrated in FIG. 16, the first image display surface 11 exists at the back of the second image display surface 12.

In this case, the portable video camera 206 may be provided with the image change switch 61 described above in the description of the first example to enable a user to change an image by operating the image change switch 61 between the case of ordinary picture taking and the case where the user takes a picture of him/herself. The arrangement may alternatively be such that image change is automatically performed according to the positional relationship between the finder and the video camera main body 206 (e.g., the distance therebetween). In this case, the arrangement may be such that the first casing 221 corresponds to the finder and the second casing 222 corresponds to the video camera main body.

The display systems in the examples can also be applied, for example, to image forming apparatuses such as copying machines and facsimile machines, automated-teller machines (ATM), signals, electronic paper, street advertisement displays, etc., as well as to electronic pocket notebooks, watches and personal computers other than notebook types.

### <Third Embodiment>

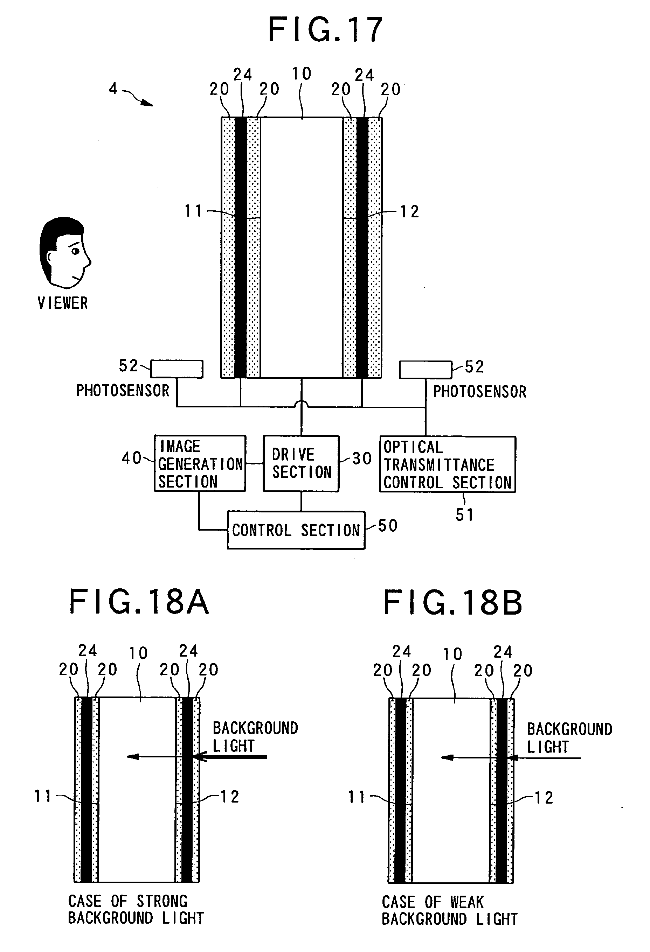

A display system in a third example of the present invention will be described with reference to FIGS. 17 and 18 . The display system in the third example is a display system capable of changing the optical transmittance of a liquid crystal, i.e., light transmission device, according to the intensity of background light. The same components as those in the display system 1 (2) in the first or second example described above are indicated by the same reference numerals and the detailed description of the same components will not be repeated.

### Basic Construction

The basic construction of the display in the third example will first be described with reference to FIG. 17. FIG. 17 is a block diagram schematically showing the basic construction of the display device in the third example.

As shown in FIG. 17, the display system 4 in the third example has a display unit 10, polarizing plates 20, a liquid crystal 24, a drive section 30, an image generation section 40, a control section 50, an optical transmittance control section 51, and photosensors 52.

The optical transmittance control section 51 changes the polarization angle (i.e., the orientation of alignment) of the liquid crystal 24 to regulate the amount of light passing through the liquid crystal 24 (and the polarizing plates 20 placed on the opposite sides of the liquid crystal 24) according to the intensity of background light detected by one of the photosensors 52.

The photosensors 52 are arranged to detect the intensity of background light. That is, the photosensor 52 placed on the first image display surface 11 side detects the intensity of background light propagating from the first image display surface 11 side to the second image display surface 12 side, and the photosensor 52 placed on the second image display surface 12 side detects the intensity of background light propagating from the second image display surface 12 side to the first image display surface 11 side.

### Principle of Operation

The principle of the operation of the display system 4 in the third example will next be described with reference to FIGS. 18A and 18B. FIGS. 18A and 18B are cross-sectional views of the display in the third example schematically showing the state of transmission of background light through the display system in the third example.

If background light propagating from the second image display surface 12 side is stronger than display light as shown in FIG. 18A, the photosensors 52 detects the intensity of the background light and outputs the detected intensity to the optical transmittance control section 51. The optical transmittance control section 51 reduces the amount of transmission of the background light by changing the polarization angle of the liquid crystal 24 placed on the second image display surface 12 side in order to avoid transmission of the background light propagating from the second image display surface 12 side. Needless to say, the optical transmittance control section 51 may change the polarization angle of the liquid crystal 24 so as to block the background light (that is, the amount of transmission is reduced to zero). The optical transmittance control section 51 may be arranged to detect the intensity of display light for comparison with the intensity of background light.

In this manner, transmission of background light can be suitably controlled (by blocking for example) no matter what the intensity of background light, thereby enabling the viewer to visually recognize more suitably the contents of a display produced by the display unit 10 without visually recognizing the background light.

If the background light propagating from the second image display surface 12 side is weaker than the display light as shown in FIG. 18B, the photosensor 52 also detects the intensity of the background light and outputs the detected intensity to the optical transmittance control section 51. The optical transmittance control section 51 determines that it is not necessary to largely reduce the amount of transmission (transmittance) of background light relative to that in the case shown in FIG. 18A, and changes the polarization angle of the liquid crystal 24. The optical transmittance control section 51 may allow transmission of the background light in such an amount that the transmitted background light is as strong as that in the case shown in FIG. 18A. Needless to say, also in the case shown in FIG. 18B, the optical transmittance control section 51 may change the polarization angle of the liquid crystal 24 so as to block the background light. Consequently, the viewer can visually recognize the display contents in a state of being uniform in quality (in terms of the amount of light, luminance or the like for example) no matter what a change in intensity of the background light. That is, the viewer can visually recognize more suitably the display contents by eliminating the influence of flicker or the like due to variation in the background light.

If the background light is so weak that it cannot be visually recognized by the viewer, it is not necessary to change the polarization angle of the liquid crystal 24. If the polarization angle of the liquid crystal 24 is not changed, the advantage of reducing the total power consumption of the display system 3 by reducing the voltage applied to the liquid crystal 24 can be obtained.

The same operations are performed with respect to background light propagating from the first image display surface 11 side.

The present invention is not limited to the aforementioned embodiments or examples. Suitable changes or modification may be made in the embodiments and the examples without departing from the gist or spirit of the invention read from the appended claims and the entire specification. Display systems and electronic appliances accompanied with such changes or modifications are also included in the technical scope of the present invention.

## Claims

1. A display system (1) comprising:
a display device including an image forming layer (111) capable of emitting display light toward both front and back sides, the display device (10)being capable of producing a display on a first surface (11) by a display light portion emitted toward the front side and producing a display on a second surface (12) at the back of the first surface by a display light portion emitted toward the back side; and
an optical transmission control device placed along at least one of the first surface and the second surface, the optical transmission control device controlling transmission of at least one of background light froma position at the back of the second surface as viewed from the first surface side and background light from a position at the back of the first surface as viewed from the second surface side.

2. The display system according to claim 1, wherein the optical transmission control device controls transmission of at least one of the display light portion emitted toward the front side and the display light portion emitted toward the back side.

3. The display system according to claim 1 or 2, wherein the optical transmission control device includes two polarizing elements (20,21) respectively placed on the first surface side and the second surface side.

4. The display system according to claim 3, wherein the two polarizing elements comprise a pair of polarizing plates placed in such a state that the polarization angles of the polarizing plates are different from each other.

5. The display system according to claim 3, wherein the polarization angle of at least one of the two polarizing elements is changed by application of a voltage.

6. The display system according to claim 1 or 2, wherein the optical transmission control device changes the optical transmittance by application of a voltage or a current.

7. The display system according to claim 1 or 2, wherein display information is displayed by the optical transmission control device.

8. The display system according to claim 1 or 2, wherein the optical transmission control device comprises a mechanical shutter (22, 23).

9. The display system according to claim 1 or 2, wherein the optical transmission control device is placed on each of the first surface side and the second surface side, the display system further comprising:
a change control device of controlling change of the two optical transmission control devices between a state of blocking the background light from the position at the back of the second surface and transmitting the display light portion emitted toward the front side, and a state of blocking the background light from the position at the back of the first surface and transmitting the display light portion emitted toward the back side.

10. The display system according to claim 9, wherein the display device comprises a spontaneous luminescence display unit which displays on the second surface a second image obtained by flipping a first image in a first state in which the first image is displayed on the first surface, and which displays the second image on the first surface in a second state in which the first image is displayed on the second surface.

11. The display system according to claim 10, further comprising a display change device (60) of controlling the display device so as to select between the first state and the second state.

12. The display system according to claim 11, wherein the display change device includes an image change switch (61) for selection according to an external operation or a predetermined operation relating to the display system.

13. The display system according to claim 11 or 12, wherein the display change device includes an image data inversion device of selecting between the first state and the second state by inverting image data input to the display device for image display on the first or second surface.

14. The display system according to any of claims 11 to 13, wherein the display device has a plurality of signal lines (15) for image display arranged on a plane along the first or second surfaces, and a signal line drive device of driving the plurality of signal lines for image display, and the display change device performs selection by reversing the order in which the plurality of signals lines for image display in the signal line drive device are driven.

15. The display system according to any of claims 11 to 14, further comprisinga first casing (211) in which the display device is accommodated, and a second casing (212) openably and closably connected to the first casing, wherein the display change device (60) controls the display device according to the opened/closed state of the second casing.

16. The display system according to any one of claims 1 to 15, wherein the display device includes an electroluminescent display device.

17. The display system according to claim 1 or 2, further comprising a photosensor (52) for detecting the intensity of the background light, and an optical transmittance control device (51) of changing the optical transmittance of the optical transmission control device on the basis of an output from the photosensor.

18. An electronic appliance (201) comprising the display system (1) according to any one of claims 1 to 17, and an operating button which influences a content of an image displayed in the display system.
